# EUROPÄISCHE PATENTSCHRIFT

(11) **EP 1 298 976 B1**
(45) Veröffentlichungstag und Bekanntmachung des Hinweises auf die Patenterteilung: **09.05.2012**
(21) Anmeldenummer: 02021490.4
(22) Anmeldetag: 25.09.2002
(51) Int. Cl.: H05K 9/00

(54) **Verfahren zur Herstellung einer elektromagnetischen Abschirmung**
Method for producing an electromagnetic shield
Méthode de fabrication d'un blindage électromagnétique

(30) Priorität: 27.09.2001 DE 10147751
(43) Veröffentlichungstag der Anmeldung: 02.04.2003
(73) Patentinhaber: Hewlett-Packard Development Company, L.P., Houston, TX 77707 (US)
(72) Erfinder: Walkling, Nicolai, 81675 München (DE)
(74) Vertreter: Samson & Partner

(56) Entgegenhaltungen:
- WO-A-01/28305
- GB-A- 2 330 953
- US-A- 6 090 728
- US-B1- 6 271 465

## Beschreibung

Die vorliegende Erfindung betrifft ein Verfahren zur Herstellung einer Schirmung gegen elektromagnetische Strahlung für auf einer Leiterplatte angeordnete Bauelemente.

In vielen Fällen sollen Bauelemente auf einer Leiterplatte gegen elektromagnetische Strahlung, sowohl gegen eine Ein- als auch eine Ausstrahlung, EMV-verträglich geschirmt werden.

Die amerikanische Patentschrift US 6,271,465 B 1 beschreibt dazu eine elektrische Abschirmung für auf Leiterplatten befindliche abzuschirmende Komponenten. Die elektrische Abschirmung besteht aus einem metallisierten Polymer-Material, beispielsweise PET, und weist wenigstens eine vorgeformte Kavität für eine Komponente auf der Leiterplatte auf. Die Abschirmung umfasst ferner an ihrem äußeren Rand und ggf. zwischen den mehreren Kavitäten Flanschflächen, mit denen die Abschirmung auf die Leiterplatte befestigt wird. Die leitende Verbindung zwischen Abschirmung und Leiterplatte wird durch dafür vorgesehene Ausbuchtungen eines Gehäuses hergestellt, die eine durch ihre Länge definierte Anpresskraft auf die außen liegenden Flanschflächen ausüben, wenn sich das Gehäuse in einer geschlossenen Position befindet. Ein vorheriges Befestigen der Abschirmung auf der Leiterplatte, beispielsweise durch Löten, entfällt. Darüber hinaus sind an den Ausbuchtungen angebrachte, starre Mittel vorgesehen, die während des Zusammensetzens der Einzelteile ein über Toleranzwerte hinaus gehendes Aufstapeln der Einzelteile verhindern.

Eine andere US-Patentschrift US 6,090,728 A befasst sich ebenfalls mit auf Leiterplatten aufbringbaren Abschirmungen. Diese beschäftigt sich vorrangig mit der Optimierung der Materialzusammensetzung von elektromagnetischen Abschirmungen für Leiterplatten. Dabei richtet die Druckschrift ihre Anforderungen darauf, eine in der Abschirmung befindliche Metallfaser-Schicht beim Formen der Abschirmung, vorzugsweise einem thermoplastischen Verfahren, nicht zu beschädigen. Es werden verschiedenste Materialzusammensetzungen beschrieben. Demzufolge wird eine leitende Verbindung der Abschirmung mit der Leiterplatte lediglich am Rand und nicht auf innen liegenden Stegen des Schirmdeckels hergestellt.

Jedoch tritt das Problem auf, dass die Leiterplatte sowie die Schirmteile erhebliche Unebenheiten aufweisen können. So kann z.B. bei der Herstellung von Mobiltelefonen eine Leiterplattenunebenheit von 1 %, auf die Leiterplattenlänge bezogen, auftreten. Bei den herkömmlichen Geräten können somit Unebenheiten von bis zu 1,3 mm vorkommen.

Daraus ergeben sich erhebliche Probleme beim Löten der Schirmteile auf die Leiterplatte aufgrund dieser Unebenheit.

Aufgabe der vorliegenden Erfindung ist es, eine Schirmung anzugeben, bei welcher die auftretenden Unebenheiten ausgeglichen werden können.

Dazu dient das eingangs genannte Verfahren, welches erfindungsgemäß dadurch gekennzeichnet ist, dass über die zu schirmenden Bauelemente ein flexibler leitfähiger Schirmdeckel aufgebracht wird, wobei der Rand und im Falle einer Aufteilung des Schirmdeckels in mehrere Kammern die innenliegenden Stege des Schirmdeckels mittels eines flexiblen Stempels in eine elektrisch leitfähige Verbindungsmasse gedrückt werden und somit eine elektrisch leitende Verbindung zwischen Leiterplatte und Schirmdeckel hergestellt wird.

Bei dem erfindungsgemäßen Verfahren wird eine flexible elektrisch leitende Verbindungsmasse auf den Schirmdeckel und/oder die Leiterplatte aufgebracht. Der flexible Stempel sorgt dafür, dass sich der flexible Schirmdeckel lückenlos an die vorbestimmten Andruckflächen auf der Leiterplatte anlehnt und mittels der Verbindungsmasse leitend auf der Leiterplatte fixiert wird. Das erfindungsgemäße Verfahren kann große Unebenheiten ausgleichen und passt sich auch später eintretenden Änderungen der Ebenheit an.

Weitere vorteilhafte Ausgestaltungen des erfindungsgemäßen Verfahrens ergeben sich aus den Unteransprüchen sowie aus der nachfolgenden Beschreibung eines Ausführungsbeispiels des erfindungsgemäßen Verfahrens anhand der Zeichnung.

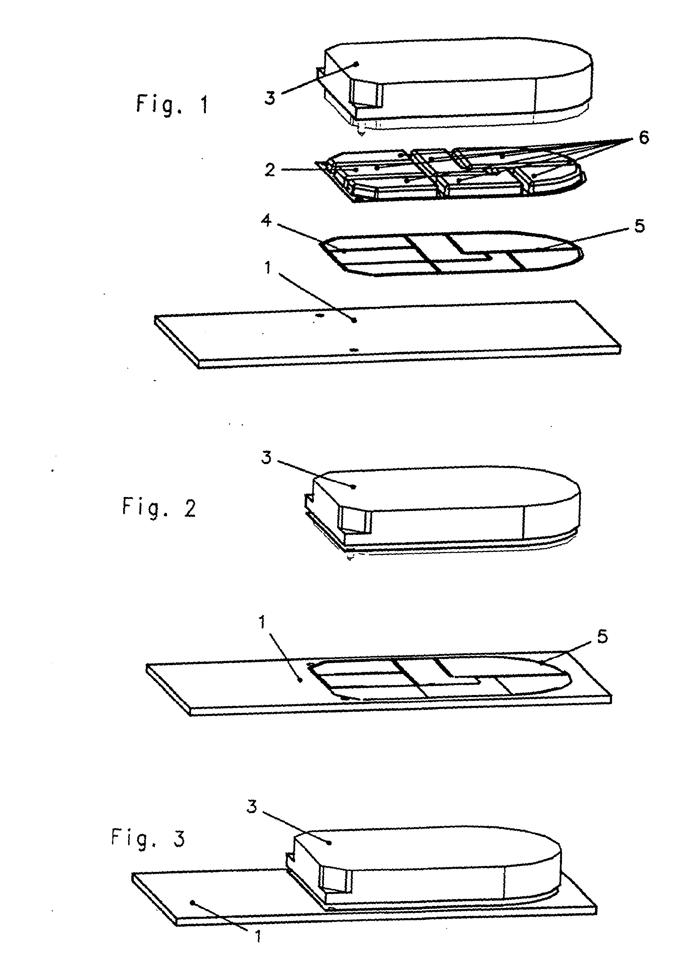

Es zeigen
Figur 1 in einer perspektivischen Explosionsdarstellung die Ausgangslage der bei einer Durchführung des erfindungsgemäßen Verfahrens verwendeten Komponenten,
Figur 2 in einer perspektivischen Explosionsdarstellung eine Anordnung der in Figur 1 verwendeten Komponenten während der Durchführung des erfindungsgemäßen Verfahrens,
Figur 3 in einer perspektivischen Darstellung eine weitere Anordnung der in Figur 1 verwendeten Komponenten während der Durchführung des erfindungsgemäßen Verfahrens,
Figur 4 in einer perspektivischen Ansicht von unten einen Stempel zur Durchführung des erfindungsgemäßen Verfahrens,
Figur 5 in einer perspektivischen Darstellung eine weitere Anordnung der in Figur 1 verwendeten Komponenten während der Durchführung des erfindungsgemäßen Verfahrens,
Figur 6 in einer Seitenansicht einen Zustand der Komponenten bei der Durchführung des erfindungsgemäßen Verfahrens, und
Figur 7 in einer Seitenansicht eine nach dem erfindungsgemäßen Verfahrens hergestellte Schirmung.

Bei dem erfindungsgemäßen Verfahren sollen Bauelemente (nicht dargestellt) auf einer Leiterplatte 1 geschirmt werden. Dazu wird ein leitfähiger Deckel 2 verwendet, welcher flexibel gestaltet ist, so dass er sich z. B. in Längsrichtung durchbiegen lässt. Dabei kann dieser Deckel unterschiedlich gestaltet sein, so kann er z. B. mehrere einzelne Kammern 6 aufweisen, mit denen bestimmte Bauelemente separat abgeschirmt werden können. Dieser Deckel weist am äußeren Umfang und zwischen den Kammern Verbindungsflächen auf, auf welche mittels eines Werkzeugs, in diesem Falle eines Stempels 3 ein Druck ausgeübt werden kann. Verbindungsflächen sind die Flächen, die sich am Schirmdeckel 3 befinden und mittels Lot, Kleber oder ähnlichem mit der Leiterplatte 1 verbunden werden.

Mittels des erfindungsgemäßen Verfahrens soll nun der Deckel 2 mit der Leiterplatte 1 z. B. mittels eines elektrisch leitfähigen Klebers verbunden werden. Dazu muss dieser Kleber auf der Leiterplatte 1 an entsprechenden Stellen aufgebracht werden und/oder auf die Verbindungsflächen des Deckels 2 aufgebracht werden.

Dieses Aufbringen kann mittels eines Dispensverfahrens vorgenommen werden. Eine andere Möglichkeit des Aufbringens des Klebers besteht darin, dass sich der Kleber auf einer Trägerfolie an entsprechenden Stellen befindet und mittels dieser Trägerfolie auf die Leiterplatte 1 aufgebracht wird. Durch das Aufdrücken der Trägerfolie auf die Leiterplatte haftet der Kleber an den entsprechenden Stellen auf der Leiterplatte 1, und nach dem Abziehen der Trägerfolie steht er für den Verbindungsvorgang zur Verfügung.

In der gleichen Art und Weise kann der Kleber mittels einer Trägerfolie auf die Verbindungsflächen des Deckels 2 aufgebracht werden.

Der eigentliche Verfahrensschritt besteht nun darin, dass mittels des Stempels die Verbindungsflächen, d.h. die Klebeflächen des Deckels mit den auf der Leiterplatte vorgesehenen Verbindungsflächen, d.h. Klebeflächen mittels des Klebers verbunden werden. Es könnte sich hier auch Lötflächen oder ähnliches handeln.

Da es sich bei dem Stempel erfindungsgemäß um einen flexiblen Stempel handelt, können die Ränder des Schirmdeckels lückenlos auf die Leiterplatte 1 aufgedrückt werden und somit können auch große Unebenheiten ausgeglichen werden.

Unter einem flexiblen Stempel ist ein Stempel zu verstehen, dessen Ränder, die den Druck auf den Schirmdeckel 2 ausüben, sich einer gebogenen Unterlage anpassen können.

Da der elektrisch leitfähige Kleber oder ähnliches eine Verbindung zwischen den beiden Teilen herstellt, ist eine zuverlässige feste und elektrisch leitende EMV-Schirmung gewährleistet.

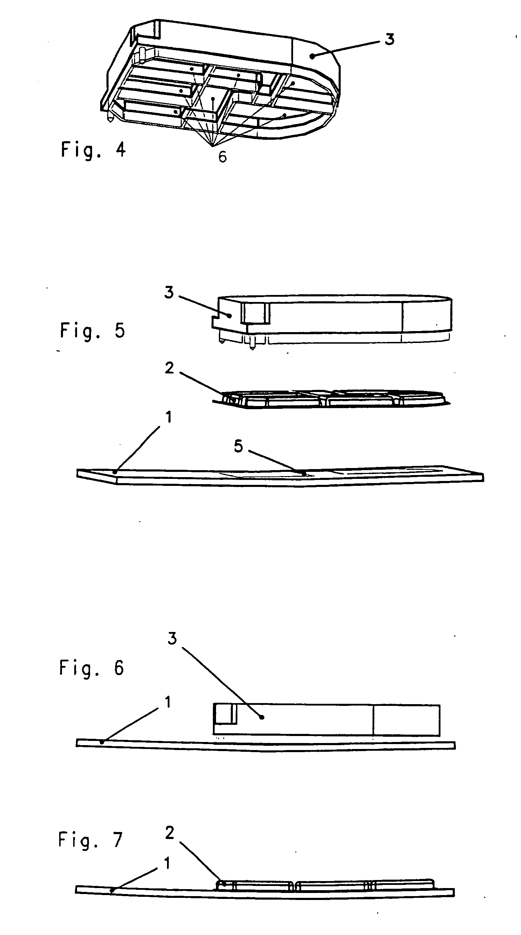

In Figur 5 ist der Zustand gezeigt, in dem vor dem Zusammenbringen von Leiterplatte 1 und Deckel 2 die Leiterplatte 1 leicht durchgebogen ist, währen der Deckel 2 noch gerade ausgerichtet ist.

Figur 6 zeigt, dass während des eigentlichen Verbindungsvorgangs der flexible Deckel 2 von dem flexiblen Stempel 3 auf die Leiterplatte 1 gedrückt wird, wobei der Stempel in der Lage ist, Unebenheiten auszugleichen. Somit wird der Deckel 2 an allen Verbindungsflächen auf die Leiterplatte 1 aufgedrückt, so dass die beiden Teile sauber miteinander verbunden werden.

Figur 7 zeigt den Endzustand, in welchem sich der flexible Deckel 2 an die durchgebogene Leiterplatte 1 angepasst hat.

Die Figuren 6 und 7 zeigen besonders gut die Durchbiegung der Leiterplatte, die auf Grund des erfindungsgemäßen Verfahrens das Aufbringen des Schirmdeckels nicht negativ beeinflusst.

Das Ausführungsbeispiel ist dahingehend beschrieben worden, dass zum Verbinden von Leiterplatte 1 und Deckel 2 ein Kleber verwendet wird. Hierzu ist festzustellen, dass das Verfahren mit Klebern der unterschiedlichsten Art durchgeführt werden kann, so lange es sich dabei um Kleber mit einer elektrischen Leitfähigkeit handelt. Diese Leitfähigkeit kann dadurch hergestellt werden, dass dem Kleber leitfähige Partikel zugesetzt werden, sie kann aber auch dadurch hergestellt werden, dass der Kleber eine leitfähige äußere Schicht aufweist.

Neben Klebern jeder Art sind auch andere leitfähige Verbindungsmassen, wie z. B. Lot, lotähnliche Verbindungsmassen oder ähnliche Verbindungsmassen denkbar.

## Patentansprüche

1. Verfahren zur Herstellung einer mit elektromagnetisch zu schirmenden Bauelementen bestückten Leiterplatte (1), **dadurch gekennzeichnet, dass** über die zu schirmenden Bauelemente ein flexibler leitfähiger Schirmdeckel (2) aufgebracht wird, wobei der Rand und im Falle einer Aufteilung des Schirmdeckels in mehrere Kammern (6) die innenliegenden Stege des Schirmdeckels mittels eines flexiblen Stempels (3), dessen Ränder, die Druck auf den Schirmdeckel ausüben, sich einer gebogenen Unterlage anpassen können, in eine elektrisch leitfähige Verbindungsmasse gedrückt werden und somit eine elektrisch leitende Verbindung zwischen Leiterplatte (1) und Schirmdeckel (2) hergestellt wird.

2. Verfahren nach Anspruch 1, **dadurch gekennzeichnet, dass** die Verbindungsmasse ein elektrisch leitfähiger Kleber ist.

3. Verfahren nach Anspruch 2, **dadurch gekennzeichnet, dass** der Kleber mittels einer Trägerfolie auf die Leiterplatte und/oder den Deckelrand aufgebracht wird.

4. Verfahren nach Anspruch 2, **dadurch gekennzeichnet, dass** der Kleber auf die Leiterplatte und/oder den Deckelrand/Verbindungsfläche dispenst wird.

5. Stempel (3) zur Herstellung einer mit elektromagnetisch geschirmten Bauelementen bestückten Leiterplatte (1), wobei der Stempel einen Rand zum Drücken eines Randes eines flexiblen Schirmdeckels in eine elektrisch leitfähige Verbindungsmasse auf der Leiterplatte aufweist, **dadurch gekennzeichnet, dass** der Stempel (3) im Falle einer Aufteilung des Schirmdeckels in mehrere Kammern (6) Ränder zum Drücken der innenliegenden Stege des Schirmdeckels in die elektrisch leitfähige Verbindungsmasse auf der Leiterplatte aufweist, und der Stempel (3) flexibel ist, sodass dessen Ränder an eine gebogene Unterlage, insbesondere eine unebene Leiterplatte (1), anpassbar sind.

## Claims

1. A method of producing a printed circuit board (1) equipped with components to be electromagnetically shielded, **characterized in that** a flexible conductive shield cover (2) is arranged over the components to be shielded, wherein the edge of the shield cover and, in the case the shield cover is partitioned into several chambers (6), the inner links of the shield cover are pressed into an electrically conductive connection material by means of a flexible stamp (3), the edges of which, which exert pressure on the shield cover, being capable of conforming a curved base, and, as a result, an electrically conductive connection between the printed circuit board (1) and the shield cover (2) is established.

2. A method according to claim 1, **characterized in that** the connection material is an electrically conductive adhesive.

3. A method according to claim 2, **characterized in that** the adhesive is applied by means of a carrier foil onto the printed circuit board and/or the cover edge.

4. A method according to claim 2, **characterized in that** the adhesive is dispensed onto the circuit board and/or the cover edge/connecting surface.

5. Stamp (3) for producing a printed circuit board equipped with components to be electromagnetically shielded, wherein the stamp comprises an edge for pressing an edge of a flexible shield cover into an electrically conductive connection material on the printed circuit board, **characterized in that**, in the case the shield cover is partitioned into several chambers (6), the stamp (3) comprises edges for pressing the inner links of the shield cover into the electrically conductive connection material on the printed circuit board, and the stamp (3) is flexible such that its edges are capable to conform a curved base, particularly an uneven printed circuit board.

## Revendications

1. Méthode de fabrication d'une plaque de circuit imprimé (1) équipée de composants pour lesquels doit être réalisé un blindage électromagnétique, **caractérisée en ce que** l'on applique par-dessus les composants pour lesquels doit être réalisé un blindage, un couvercle de blindage (2) conducteur et flexible, la bordure dudit couvercle de blindage et, dans le cas d'une subdivision du couvercle de blindage en plusieurs compartiments (6), les nervures de cloisonnement situées à l'intérieur, étant pressées dans un mastic d'assemblage électriquement conducteur, au moyen d'un poinçon flexible (3) dont les bordures, qui exercent une pression sur le couvercle de blindage, peuvent s'adapter à une base d'appui courbe, cette opération établissant ainsi une liaison électriquement conductrice entre la plaque de circuit imprimé (1) et le couvercle de blindage (2).

2. Méthode selon la revendication 1, **caractérisée en ce que** le mastic d'assemblage est une colle électriquement conductrice.

3. Méthode selon la revendication 2, **caractérisée en ce que** la colle est appliquée au moyen d'une feuille de support sur la plaque de circuit imprimé et/ou sur la bordure de couvercle.

4. Méthode selon la revendication 2, **caractérisée en ce que** la colle est distribuée sur la plaque de circuit imprimé et/ou la bordure de couvercle/la surface d'assemblage.

5. Poinçon (3) pour la fabrication d'une plaque de circuit imprimé (1) équipée de composants pour lesquels doit être réalisé un blindage électromagnétique, le poinçon comportant une bordure destinée à presser une bordure d'un couvercle de blindage flexible dans un mastic d'assemblage électriquement conducteur sur la plaque de circuit imprimé, **caractérisé en ce que** le poinçon (3), dans le cas d'une subdivision du couvercle de blindage en plusieurs compartiments (6), comporte des bordures pour presser les nervures de cloisonnement du couvercle de blindage situées à l'intérieur, dans le mastic d'assemblage électriquement conducteur sur la plaque de circuit imprimé, et **en ce que** le poinçon (3) est flexible, de sorte que ses bordures peuvent s'adapter à une base d'appui courbe, notamment à une plaque de circuit imprimé (1) non plane.
